# EUROPEAN PATENT APPLICATION

(11) **EP 3 046 142 A1**
(43) Date of publication of application: **20.07.2016**
(21) Application number: 15200196.2
(22) Date of filing: 15.12.2015
(51) Int. Cl.: H01L 21/687, H01L 21/02, H01L 21/67

(54) **SUPPORT STAGE FOR VACUUM APPARATUS**

(30) Priority: 14.01.2015 GB 201500541
(71) Applicant: UHV Design Limited, Laughton, Sussex BN8 6BN (GB)
(72) Inventor: COXON, Peter, Laughton, Sussex BN8 6BN (GB)
(74) Representative: Wynne-Jones, Laine and James LLP

(57) **Abstract**

Apparatus for supporting a substrate (11) in respect of a vacuum system comprising a vacuum chamber, a cooling system (12), and a cradle (6) for supporting a substrate holder and configured such that, in use, the substrate holder is thermally coupled with said cooling system, the apparatus comprising a substrate holder (20, 20') comprising a thermally conductive diaphragm spring (9, 9') mounted within a support ring and defining a slot (11 a) therebetween for receiving a substrate (11), in use.

## Description

This invention relates generally to a support stage for holding and manipulating a substrate material within a vacuum chamber and, more particularly but not necessarily exclusively, to a manipulator stage for a vacuum or ultra-high vacuum material deposition/modification apparatus.

Ultra-high vacuum (UHV) is a vacuum regime characterised by pressures of the order of 10⁻⁷ pascals, or less, and is used in many applications, including surface analytic techniques and thin film growth and preparation techniques with stringent requirements for purity, such as molecular beam epitaxy (MBE), UHV chemical vapour deposition (CVD) and UHV pulsed laser deposition (PLD). It is typical, in such applications, to hold a substrate material, such as a semiconductor wafer, metal or ceramic substrate, glass or even polymeric material on a specialised manipulator in a vacuum/UHV environment in close proximity to a source or system of sources.

A UHV manipulator allows an object which is inside a vacuum chamber and under vacuum to be mechanically positioned. It may provide linear motion, rotary motion or (more often) a combination of both. To generate the mechanical movement inside the chamber, two basic mechanisms are commonly employed: a mechanical coupling through the vacuum wall (using a vacuum-tight seal around the coupling), or a magnetic coupling that transfers motion from air-side to vacuum-side, although other techniques may be known and the present invention is not necessarily intended to be limited in this regard. Various forms of motion control are available for manipulators, including (but not limited to) knobs, handwheels, motors, stepping motors (external or in vacuo), piezoelectric motors and pneumatics.

In general, and in many applications, the above-mentioned sources produce a tightly controllable flux/multiple simultaneous fluxes of high purity elements and compounds by for example (but by no means limited to):
- thermal evaporation / sublimation, through direct heating, electron beam heating, laser beam heating, cathodic arc heating
- plasma sputtering of a target material
- CVD (Chemical Vapour Deposition) of precursor compounds

In typical embodiments, the specialised stage (including the manipulator) upon which the substrate is loaded currently is required to provide some or all of the following functionality:
- a platform upon which the substrate is loaded and typically made from refractory material or other high temperature material;
- the platform to be rotatable about an axis normal to the substrate surface, and generally but not always passing through its centre, by means of a UHV rotary coupling and without degrading the vacuum pressure;
- the platform may also have a degree of axial motion to fine tune the deposition characteristics and / or to facilitate substrate transfer by increasing the gap between the heater and cradle to facilitate loading of a wafer and closing the gap again to provide better, in the sense of uniformity and higher temperature, heating;
- usually a high temperature radiant heating facility in close proximity to the back side of the substrate, such that the substrate can be continuously rotated and heated at up to 1200°C, for example;
- a means by which the substrate temperature can be measured, such as a thermocouple; and
- often a means to bias the substrate with DC or RF voltages to either
   o fine tune the deposition kinetics; or
   o create a plasma to sputter clean the substrate material prior to deposition.

The above-mentioned heating facility is key, in many applications, as the surface free energy provided to the deposited material / evaporant by the thermal excitation in the substrate can be used to tune the deposition kinetics in order to create different surface stoichiometries or different surface structures such as epitaxial layers.

The rotary motion is also usually key, and employed to
o average out any inhomogeneities in heater temperature / heat flux such that the substrate temperature is as uniform as possible across the entire surface;
o and to average out the effect of any inhomogeneities in deposition flux from the sources as described above such that the deposited layer thickness is as uniform as possible

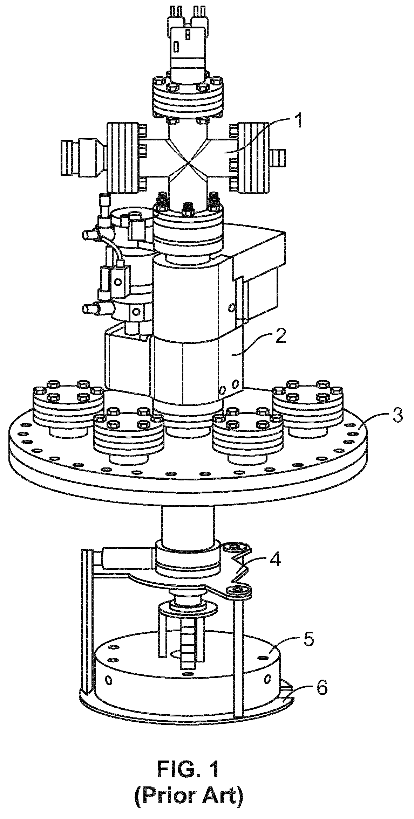

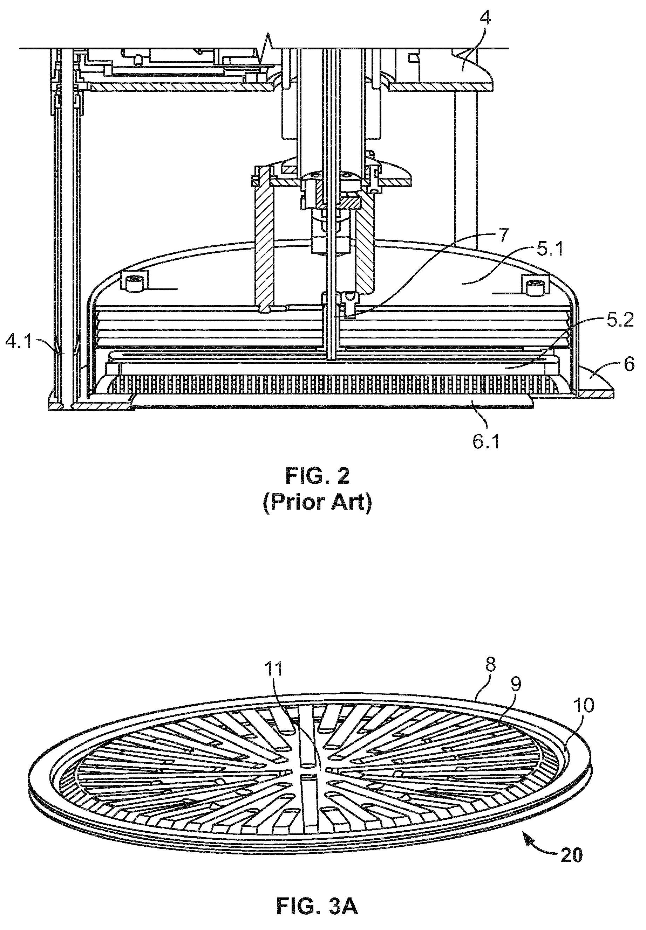

Several such stages are known, and an example of one such stage will now be described with reference to Figures 1 and 2 of the accompanying drawings, in order to illustrate key aspects of the requirements for such devices in accordance with the above.

Thus, referring to Figures 1 and 2 of the drawings, a known manipulator stage comprises a service collar 1 providing feedthroughs for power, RF and thermocouples, a combined rotary/linear magnetically coupled drive 2 and a mounting flange 3. Coupled to the rotary drive 2, there is provided a rotatable cradle support system 4 including an RF bias connection 4.1. A stationary heater module 5 is mounted below the cradle support system 4, and comprises heat shields 5.1 and a heater element 5.2, with a thermocouple 7 being provided vertically through the centre of the heater module 5. Finally, a substrate cradle 6 is provided below the heater element 5, in which a substrate material 6.1 can be supported, in use.

With the advent of advances in materials science and new applications, there is an increasing need to also provide such stages with an ability to cool the substrates either during or immediately after a deposition sequence.

This is driven by three main applications, two of which are:
- Throughput - where the need is to simply cool a substrate as quickly as possible after a heat run in order to complete the next process, or load another sample to process.
- Deposition onto heat sensitive materials such as polymer substrates used in organic electronics such as OLEDs, which may degrade or even melt under the heat load from typical deposition sources such as magnetrons, e-beam evaporators, k-cells etc.

For both of the above water or gas cooling may be sufficient. However, a third application is that of lift-off, which is used for photolithography. Photolithography's accuracy and scalability have made it the method of choice for sub-micron-scale definition of single-crystal semiconductor devices for over half a century. Unfortunately, organic semiconductor devices are chemically incompatible with the types of resists, solvents, and etchants traditionally used. There is increasing work using uncommonly used chemically inert resist methods that rely on physical phase changes for lift-off patterning of thin films of organic semiconductors and metals. Typically a resist gas is flowed over a cryogenically cooled substrate, where it freezes solid. This layer can then be patterned by thermal excitation in a number of ways to define the areas where the desired thin film is to remain. After the desired thin film or films are deposited, the substrate is brought up above the resist material's sublimation point, leaving behind only the intended pattern. All the unwanted regions are lifted-off by the subliming resist. Carbon dioxide, which solidifies at -78.5°C is sometimes used as the sublimable mask material, and for such an application LN2 cooling would be required.

In the past, stages have been provided by UHVD, where the cradle supporting the substrate could be cooled (down to -120°C, for example).

However, means also need to be provided to ensure good thermal contact to the substrate itself, typically a 4" or 6" semiconductor (e.g. Si wafer), in order to ensure good cooling performance, rather than just a cooling facility to the substrate cradle.

Clamping to a semiconductor wafer is not straightforward as the materials are typically friable, and furthermore, were the substrate to be clamped at its periphery alone there would be a substantial temperature gradient between the centre and the periphery.

The thermal contact between the substrate and cradle should not be too good during a heating cycle, and would in fact be disadvantageous.

Therefore, it would be desirable to provide a stage and means to support a substrate in same, whereby the substrate is in poor thermal contact during a heat cycle up to 1200°C, but can then be transformed, by a simple robust means external to the UHV environment, into a mode where the substrate is in good thermal contact with a suitably cooled body, in order to cool the substrate to room temperature or even cryogenic temperatures as quickly as possible, and it is an object of exemplary embodiments of the present invention to address this issue.

In accordance with an aspect of the present invention, there is provided apparatus for supporting a substrate in respect of a vacuum system comprising a vacuum chamber, a cooling system, and a cradle for supporting a substrate holder and configured such that, in use, the substrate holder is thermally coupled with said cooling system, the apparatus comprising a substrate holder comprising a thermally conductive diaphragm spring mounted within a support ring and defining a slot therebetween for receiving a substrate, in use.

The diaphragm spring may comprise a plurality of elongate, thermally conductive fingers extending radially inwardly from a circumferential edge. The circumferential edge of the diaphragm spring may be held in or on, and thermally coupled with, the support ring. The support ring may comprise an inner groove, within which the diaphragm spring is received, and the diaphragm spring may be held within the groove by an annular circlip.

In one exemplary embodiment of the invention, each of the fingers may include a sloping section which slopes upwardly from the circumferential edge of the diaphragm spring to a substantially horizontal central portion, and wherein the sloping and horizontal central portions of the fingers define a slot between the diaphragm spring and a lower edge of the support ring for receiving a substrate.

In an alternative exemplary embodiment of the invention, each of the fingers may include a sloping section which slopes upwardly from the circumferential edge of the diaphragm spring to a downwardly sloping central portion, the distal end of which terminates at or adjacent a lower plane defined by the circumferential edge of the diaphragm spring, and wherein the fingers define a slot between the diaphragm spring and the lower edge of the support ring for receiving a substrate.

Each finger may include a further upwardly sloping portion at its distal end.

In an exemplary embodiment, the aspect ratios (i.e. the ratios of length to cross-sectional areas) of the fingers are optimised to ensure each finger contacts the substrate with an appropriate force, and that the thermal conductivities of the fingers are compensated for their differing lengths, in order to ensure the most efficient cooling and best temperature uniformity during cooling of the substrate.

In accordance with one aspect of the invention, there may be provided apparatus as defined above for supporting and manipulating a substrate in respect of a vacuum system comprising a vacuum chamber, heating and cooling systems, a cradle for supporting a substrate holder and motive means for, in use, moving said cradle between a first position in which it is spaced apart from said heating system and a second position in which said substrate holder is thermally coupled with said cooling system, wherein said heating system comprises a heater element located on a plane at a lower end of said vacuum chamber and said cooling system comprises an annular cooling tank having a wall which is located at said plane, wherein said first position comprises a lowered position, wherein said cradle is spaced apart in relation to said plane, and said second position comprises a raised position, wherein said cradle is substantially adjacent to said plane.

Another aspect of the invention may extend to a method of manipulating a substrate in respect of a vacuum system comprising a vacuum chamber, heating and cooling systems, a cradle for supporting a substrate holder and motive means for axially moving said cradle between a first position in which it is in spaced apart relation to said heating system, and a second position in which it is thermally coupled with said cooling system, and the apparatus as defined above, the method comprising: performing a heating run, during which said heating system is operative and said cradle is in said first position; switching off said heating system at the end of said heating run; and moving said cradle to said second position such that said support ring is in thermal contact with said cooling system.

Yet another aspect of the invention may extend to a manipulator stage for a vacuum system comprising a vacuum chamber, a heating system and a cooling system, the stage comprising a cradle for supporting a substrate holder and motive means for moving said cradle between a first position in which it is in spaced apart relation to said heating system, and a second position in which it is thermally coupled with said cooling system, the stage further comprising a substrate holder comprising a thermally conductive diaphragm spring mounted within a support ring and defining a slot therebetween for receiving a substrate, in use.

In this case, the vacuum system may include motive means for rotating said cradle whilst it is in said second position.

The present invention may extend still further to a vacuum system comprising a vacuum chamber, a heating system, a cooling system and a manipulator stage as defined above.

These and other aspects of the present invention will be apparent from the following specific description in which embodiments of the present invention are described, by way of examples only, and with reference to the accompanying drawings, in which:
Figure 1 is a schematic perspective view of the heating stage of a UHV apparatus according to the prior art;
Figure 2 is a schematic partial cross-sectional view of the heating stage of Figure 1;
Figure 3A is a schematic perspective view of a substrate holder for use in apparatus according to a first exemplary embodiment of the present invention;
Figure 3B is a schematic perspective view of a substrate holder for use in apparatus according to a second exemplary embodiment of the present invention;
Figure 4A is a schematic cross-sectional view of the substrate holder of Figure 3A;
Figure 4B is a schematic cross-sectional view of the substrate holder of Figure 3B;
Figure 5 is a schematic cross-sectional view of a manipulator stage of a UHV apparatus, including the substrate holder of either Figure 3A or Figure 3B in the cradle support thereof;
Figure 6 is a schematic partial cross-sectional view of the manipulator stage of Figure 5, showing the cradle raised into the cooling position;
Figure 7A is a schematic partial close-up view of the substrate holder of Figure 3A in the raised configuration of Figure 6;
Figure 7B is a schematic partial close-up view of the substrate holder of Figure 3B in the raised configuration of Figure 6;
Figure 8 is a schematic perspective view of an alternative manipulator stage in which embodiments of the present invention could be employed; and
Figure 9 is a schematic partial cross-sectional view of a substrate holder for use in apparatus according to yet another exemplary embodiment of the invention.

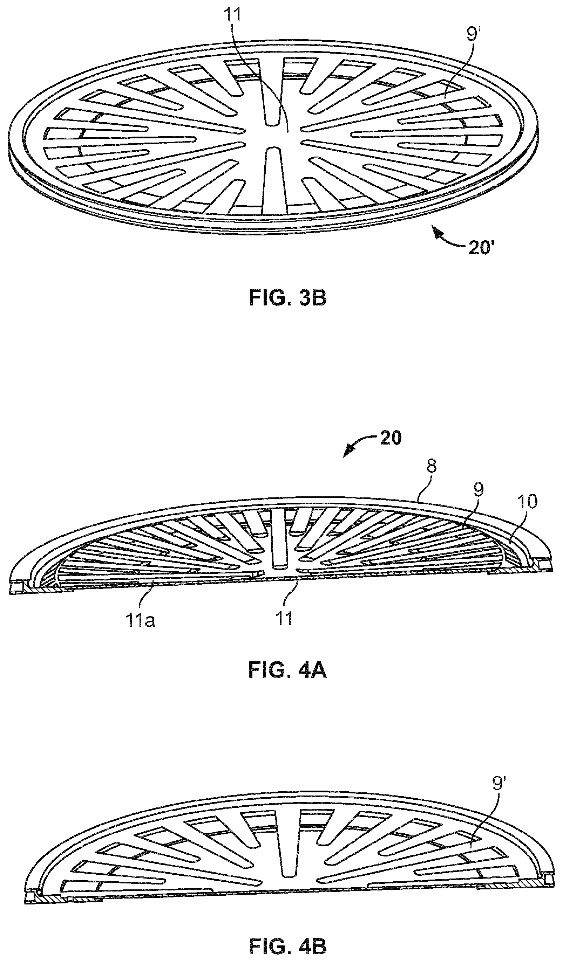

Referring to Figures 3A and 4A of the drawings, a substrate holder 20 for use in a first exemplary embodiment of the present invention comprises an outer support ring 8, which includes a feature such as a groove which can be used to grab/hold the item during substrate transfer, and a diaphragm finger spring 9 comprising resiliently flexible fingers which extends radially inward from the outer support ring 8. A circlip 10 holds the outer support ring 8 and diaphragm finger spring 9 together such that the gap between the spring 9 and the outer support ring 8 defines a slot 11 a in which a substrate material 11 (which may be a semiconductor wafer of 2 - 8" diameter) can be held.

Referring particularly to Figure 4 of the drawings, it can be seen that the diaphragm finger spring 9 is held loosely within the support ring 8, by means of the circlip 10, with the 'finger tips' slightly above the substrate 11 itself. Thus, in the heating mode, when the substrate is held in the holder below the heater module, the diaphragm finger spring 9 will not be in contact with the substrate 11 or impact its heating, other than to the degree that its material masks the substrate from the radiated heat, as required.

Referring to Figures 3B and 4B of the drawings, a substrate holder 20' for use in a second exemplary embodiment of the present invention is similar in most respects to that illustrated and described with reference to Figures 3A and 4A of the drawings, except in this case, the resiliently flexible fingers of the diaphragm finger spring 9' are substantially planar and do not have the folded tip at their respective ends.

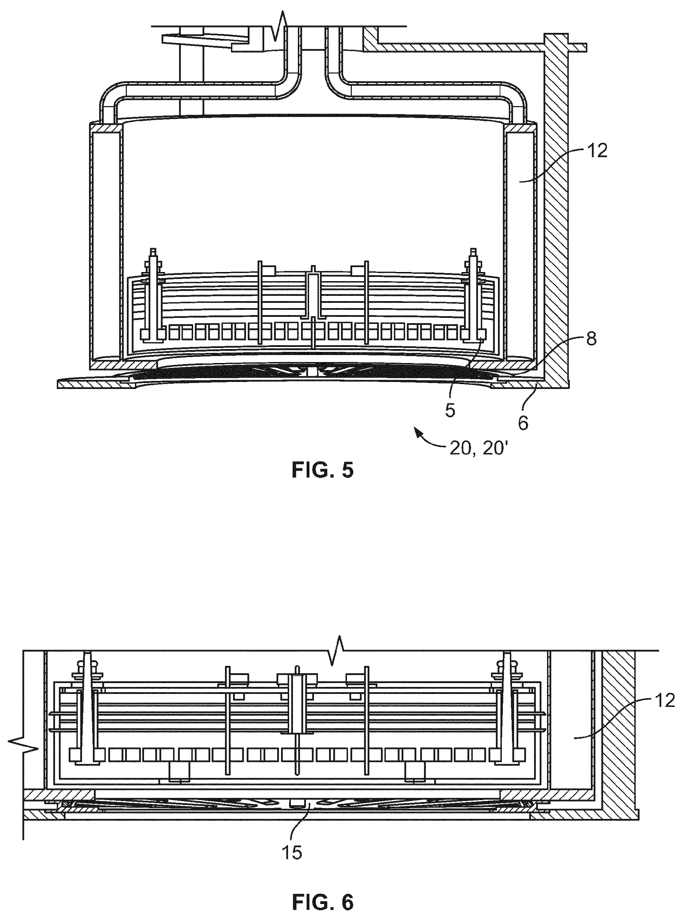

Referring to Figure 5 of the drawings, the substrate holder 20 or 20' sits in the substrate cradle 6 of a UHV apparatus such as that illustrated and described above with reference to Figures 1 and 2 of the drawings. In the illustrated apparatus, an annular cooling tank 12 is provided around the heater module (5), through which may be flowing a cooling gas or liquid, such as air, cooled N₂ gas, water, cooled alcohol, liquid N₂ or the like. The cradle 6 may be configured to be moved axially between a first lowered (substrate transfer), second lowered (heating), configuration and a third raised (cooling), configuration. In Figure 5, the cradle 6 is illustrated in a second lowered configuration, in which the substrate holder 20 or 20' is not in contact with the cooling tank 12 and the spring fingers are not in contact with the substrate (as shown in Figures 4A and 4B of the drawings). Whilst the substrate holder 20 or 20' is in this configuration, the heat run is performed, during which the substrate is heated radiantly by the heater module 5, there being minimal thermal contact between the fingers of the spring 9 or 9' and the substrate.

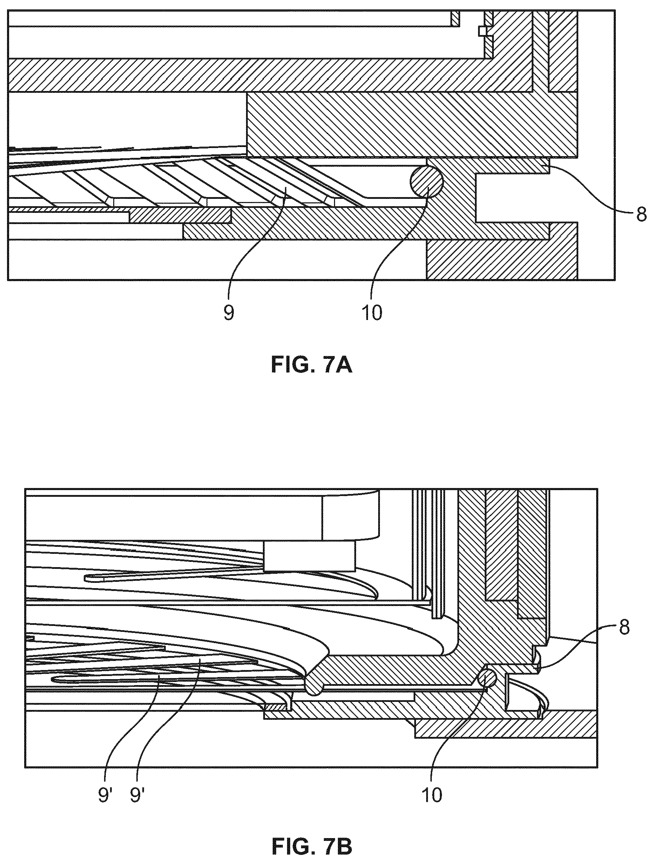

Referring now to Figures 6 and 7A and 7B of the drawings, at the end of a heat run, in order to cool the substrate rapidly, the cradle 6 is raised such that the special substrate holder 20 or 20' is firmly clamped between cradle 6 and the annular cooling tank 12.

In the process of doing this, it can be seen from Figures 6 and 7A and 7B that the following sequence ensues:
a) In the case of either the first exemplary diaphragm finger spring 9 (Figures 3A and 4A) or the second exemplary diaphragm finger spring 9' (Figures 3B and 4B), the diaphragm finger spring 9 or 9' contacts the cooling tank 12 first and cools the finger spring;
b) this then causes the periphery of the finger spring 9 or 9' to be pushed firmly down into the outer support ring 8, cooling it in the process
c) the fingers are then forced to bend, such that (at least) the ends of the fingers 15 contact the substrate 11 itself cooling the substrate where they touch it, and pushing the substrate firmly against the support ring which is now being cooled;
d) finally the outer support ring 8 is firmly clamped between the cradle 6 and cooling tank 12 and thereby cools the periphery of the substrate.

This is all acomplished using the standard axial motion positioning system normally incorporated to facilitate sample transfer, from the above-mentioned first position where the cradle is lowered much further, thereby increasing the gap between the cradle and the heater to facilitate sample transfer.

The specific stage described above only provides cooling for a nonrotating platform, and the cradle rotation must first be stopped before pulling it up against the static cooling tank.

In order to provide cooling during rotation it would be sufficient to mount the cradle and cooling tank from an alternative vacuum rotary feedthrough such as a ferro-fluidic rotary coupling or a differentially-pumped rotary feedthrough, such that the substrate, holder and cooling tank can all be rotated simultaneously.

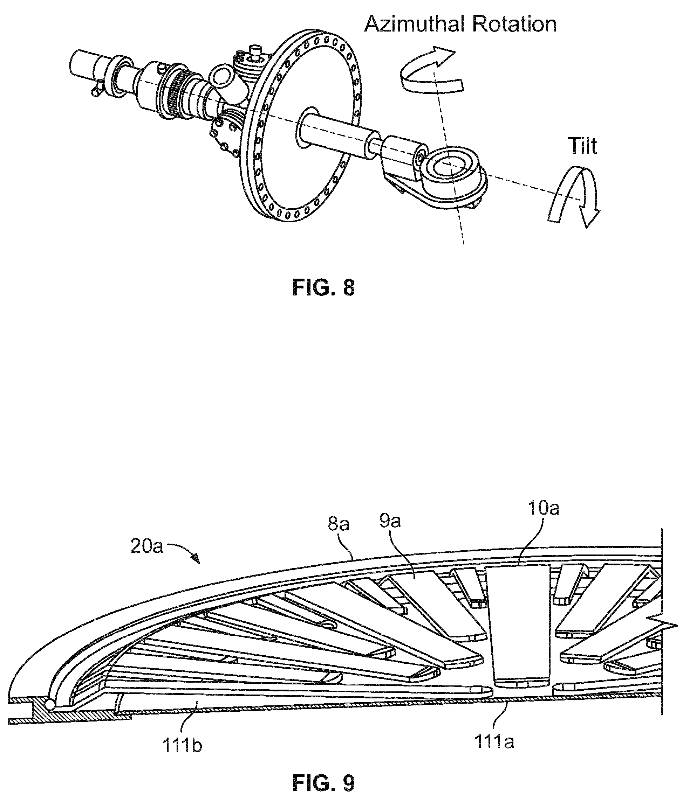

Alternative stages are known, whereby the substrate surface plane is normal to mounting flange (see Figure 8), and where similar requirements to cool substrates exist. This style of stage, in fact, has two rotations: rotation of the substrate about an axis normal to the surface, passing through the centre of the substrate, as in the arrangement described above, and referred to as azimuthal rotation; and primary rotation / substrate tilt about an axis lying in the plane of the sample surface and essentially normal to the mounting flange.

It is envisaged that a similar 'Diaphragm Finger Spring' component could be employed in this style of stage, to effect the same enhanced cooling performance, albeit with a somewhat more complex cooling tank arrangement, especially for the operating mode where continuous azimuthal rotation and simultaneous cooling is envisaged.

Referring to Figure 9 of the drawings, a substrate holder 20a for use in apparatus according to yet another exemplary embodiment of the invention again comprises an outer support ring 8a, which includes a feature such as a groove which can be used to grab/hold the item during substrate transfer, and a diaphragm finger spring 9a comprising resiliently flexible fingers which extends radially inward from the outer support ring 8a. A circlip 10a holds the outer support ring 8a and diaphragm finger spring 9a together such that the gap between the spring 9a and the outer support ring 8a defines a slot 111 b in which a substrate material 111 a (which may be a semiconductor wafer of 2 - 8" diameter) can be held.

It can be seen that the diaphragm finger spring 9a is held quite tightly within the support ring 8a, with the 'finger tips' resiliently flexed against the substrate 111 a itself. Thus, in use, when the cradle is in thermal contact with a cooling system, the diaphragm spring will maintain constant thermal coupling against the substrate, in systems where no heating and only cooling is required.

Whilst embodiments of the present invention have been described above, by way of examples only, with particular reference to UHV material deposition and manipulation apparatus, it will be appreciated by a person skilled in the art that the claimed apparatus may be equally suitable for use in many different applications wherein a substrate is required to be held and manipulated within a vacuum chamber, and the present invention is not necessarily intended to be limited in this regard. Indeed, it will be apparent to a person skilled in the art from the foregoing description that modifications and variations can be made to the described embodiments without departing from the scope of the invention as claimed.

## Claims

1. Apparatus for supporting a substrate in respect of a vacuum system comprising a vacuum chamber, a cooling system, and a cradle for supporting a substrate holder and configured such that, in use, the substrate holder is thermally coupled with said cooling system, the apparatus comprising a substrate holder comprising a thermally conductive diaphragm spring mounted within a support ring and defining a slot therebetween for receiving a substrate, in use.

2. Apparatus according to claim 1, wherein the diaphragm spring comprises a plurality of elongate, thermally conductive fingers extending radially inwardly from a circumferential edge.

3. Apparatus according to claim 2, wherein the circumferential edge of the diaphragm spring is held in or on, and thermally coupled with, the support ring.

4. Apparatus according to claim 3, wherein the support ring comprises an inner groove, within which the diaphragm spring is received; and optionally wherein the diaphragm spring is held within the groove by an annular circlip.

5. Apparatus according to any of claims 2 to 4, wherein each of the fingers is substantially planar along its length; or wherein each of the fingers includes a sloping section which slopes upwardly from the circumferential edge of the diaphragm spring to a substantially horizontal central portion, and wherein the sloping and horizontal central portions of the fingers define a slot between the diaphragm spring and a lower edge of the support ring for receiving a substrate.

6. Apparatus according to any of claims 2 to 4, wherein each of the fingers includes a sloping section which slopes upwardly from the circumferential edge of the diaphragm spring to a downwardly sloping central portion, the distal end of which terminates at or adjacent a lower plane defined by the circumferential edge of the diaphragm spring, and wherein the fingers define a slot between the diaphragm spring and the lower edge of the support ring for receiving a substrate.

7. Apparatus according to claim 5 or claim 6, wherein each finger includes a further upwardly sloping portion at its distal end.

8. Apparatus according to any of claims 2 to 7, wherein said substrate holder comprises a plurality of elongate, thermally conductive fingers extending radially inwardly from a circumferential edge, wherein said fingers are of at least two different lengths.

9. Apparatus according to claim 8, wherein the longest fingers define segments in respect of said support ring, and one or more shorter fingers are provided between said longest fingers.

10. Apparatus according to claim 7 or claim 9 wherein the aspect ratios of each of said fingers is such that the resilient flexing force exerted thereby on said substrate is appropriate to achieve the correct degree of cooling at each respective location; and/or wherein the thermal conductivities of each of said fingers are appropriate to achieve the correct degree of cooling at each respective location.

11. Apparatus according to any of the preceding claims for supporting and manipulating a substrate in respect of a vacuum system comprising a vacuum chamber, heating and cooling systems, a cradle for supporting a substrate holder and motive means for, in use, moving said cradle between a first position in which it is spaced apart from said heating system and a second position in which said substrate holder is thermally coupled with said cooling system, wherein said heating system comprises a heater element located on a plane at a lower end of said vacuum chamber and said cooling system comprises an annular cooling tank having a wall which is located at said plane, wherein said first position comprises a lowered position, wherein said cradle is in spaced apart relation to said plane, and said second position comprises a raised position, wherein said cradle is substantially adjacent to said plane.

12. A method of manipulating a substrate in respect of a vacuum system comprising a vacuum chamber, heating and cooling systems, a cradle for supporting a substrate holder and motive means for axially moving said cradle between a first position in which it is in spaced apart relation to said heating system, and a second position in which it is thermally coupled with said cooling system, and the apparatus according to claim 11, the method comprising: performing a heating run, during which said heating system is operative and said cradle is in said first position; switching off said heating system at the end of said heating run; and moving said cradle to said second position such that said support ring is in thermal contact with said cooling system.

13. A manipulator stage for a vacuum system comprising a vacuum chamber, a heating system and a cooling system, the stage comprising a cradle for supporting a substrate holder and motive means for moving said cradle between a first position in which it is in spaced apart relation to said heating system, and a second position in which it is thermally coupled with said cooling system, the stage further comprising a substrate holder comprising a thermally conductive diaphragm spring mounted within a support ring and defining a slot therebetween for receiving a substrate, in use.

14. A manipulator stage according to claim 13, wherein said vacuum system includes motive means for rotating said cradle whilst it is in said second position.

15. A vacuum system comprising a vacuum chamber, a heating system, a cooling system and a manipulator stage according to claim 13 or claim 14.
